Europäisches Patentamt

**European Patent Office**

**Office européen des brevets**

(11) Veröffentlichungsnummer: **0 151 275**

**B1**

(12) **EUROPÄISCHE PATENTSCHRIFT**

(45) Veröffentlichungstag der Patentschrift:
06.03.89

(21) Anmeldenummer: **84115188.9**

(22) Anmeldetag: **12.12.84**

(51) Int. Cl.⁴: **H 03 H 9/64,** H 03 H 9/44

(54) Mit reflektierten akustischen Wellen arbeitendes Elektronik-Bauelement.

(30) Priorität: **09.02.84 DE 3404618**

(43) Veröffentlichungstag der Anmeldung:
**14.08.85 Patentblatt 85/33**

(45) Bekanntmachung des Hinweises auf die Patenterteilung:
**06.03.89 Patentblatt 89/10**

(84) Benannte Vertragsstaaten:
**DE FR GB**

(56) Entgegenhaltungen:
**EP-A-0 100 997**

(73) Patentinhaber: **Siemens Aktiengesellschaft Berlin und München, Wittelsbacherplatz 2, D-8000 München 2 (DE)**

(72) Erfinder: **Riha, Gerd, Dr., Lerchenauer Strasse 19, D-8000 München 40 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1989

## Beschreibung

Die vorliegende Erfindung bezieht sich auf ein Elektronik-Bauelement, wie es im Oberbegriff des Patentanspruchs 1 angegeben ist.

In der EP-A-0 066 281, in der EP-A-0 089 617 und insbesondere in der EP-A-0 100 997 sind mit akustischen Wellen arbeitende Elektronik-Bauelemente und insbesondere Verbesserungen zu bekannten derartigen Bauelementen beschrieben. Solche Bauelemente arbeiten mit mehr oder weniger nahe der Oberfläche eines Substrates sich fortpflanzenden akustischen Wellen, die - allerdings mehr pauschal - als Oberflächenwellen bezeichnet werden und zu denen Rayleigh-Wellen, Bleustein-Wellen, Surface-Skimming-Bulk-Wellen (SSB-Wellen), Love-Wellen und dergleichen gehören.

In der EP-A-0 100 997, veröffentlicht am 22.2.84, ist eine zur Erreichung einer vorgegebenen Übertragungsfunktion vorzusehende "Finger"-Wichtung angegeben, d. h. eine Maßnahme zur Wichtung der als Finger bezeichneten Reflektorelemente einer jeweiligen Reflektorstruktur des Bauelementes. Weitverbreitet üblich ist es, eine derartige Fingerwichtung in der Weise vorzunehmen, daß die für die Reflexion der akustischen Welle aktiven Anteile eines solchen allgemein auch als Finger bezeichneten Reflektorelementes unterschiedlich lang gemacht werden. Dies wird als Fingerlängen-Wichtung bezeichnet.

In der EP-A-0 066 281 ist zum Zwecke der Fingerwichtung eine Fingerverschiebung für die Finger bzw. Fingergruppen einer dispersiven Verzögerungsleitung, vorgesehen für ein Pulskompressionsfilter, angegeben. Es sind dort ganze, ungeteilte Finger bzw. Fingergruppen gegenüber einer Position verschoben, in der diese Finger funktionell ungewichtet wirksam sein würden.

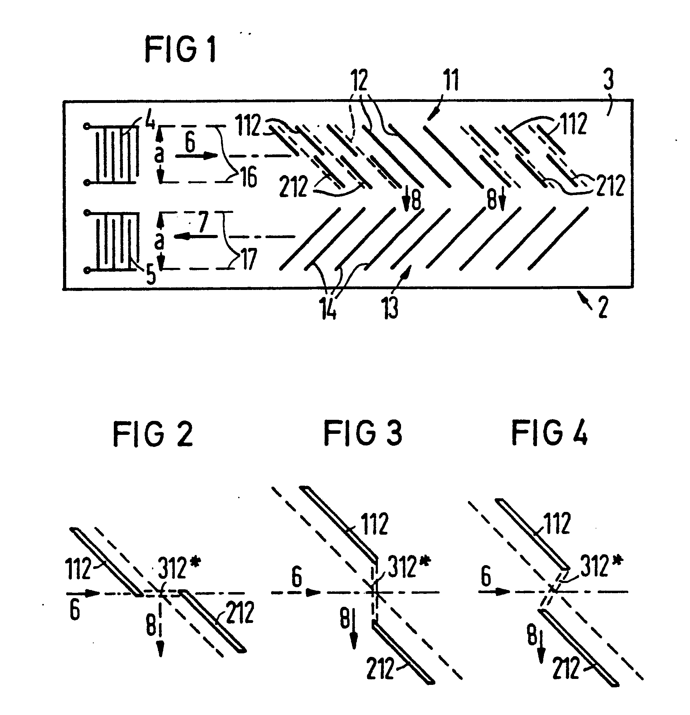

In der US-A-4 327 340 sind mit den Figuren 8 bis 12 verschiedenartige Fingerwichtungen für eine jeweilige Reflektorstruktur angegeben. Soweit die Reflektorfinger in das Substrat eingebrachte Gräben sind, ist für die Wichtung Variation der Grabenbreite und/oder -periode (Positionswichtung) oder Variation der Grabentiefe oder -dicke dargestellt. Weitere bekannte Wichtungsmöglichkeiten zeigen die Figuren 10 bis 12, nämlich die schon erwähnte Fingerlängen-Wichtung, Fingerverdünnungs-Wichtung und Fingerdot-Wichtung. Eine Variation der Fingerlängen-Wichtung zeigen "Electronics Letters" Bd. 16 (1980), S. 793 - 794, insbesondere Figur 1, und die US-A-4 365 220, insbesondere Figur 9 data. In "Electronics handelt es sich um Fingerlängen-Wichtung mit variabler Aufteilung der verbleibenden Fingerlängen auf die vorgegebene maximale Fingerlänge. In der US-PS sind die verbleibenden Fingerlängen weit weniger stark variiert, als dies für die vorgenannte Druckschrift der Fall ist. Auch in der US-PS ist variierte Verteilung der Fingerlängen vorgesehen. Für die beiden Druckschriften gilt jedoch gleichermaßen, daß die jeweiligen verbliebenen Fingerlängen in ihrer Position zur quer zu diesen Fingerlängen verlaufenden akustischen Welle sich an genau dem Ort befinden, an dem sich ein korrespondierender ungewichteter Finger befinden würde, d.h. eine wie noch nachfolgend im Zusammenhang mit der Erfindung erörterte Verschiebung von Fingerelementen gegeneinander liegt nicht vor.

Die in der Europäischen Anmeldung EP-A-100 997 vorgeschlagene Wichtung sieht vor, eine wenigstens wesentlich überwiegende Anzahl, insbesondere aller, der Reflektorelemente (auch als Finger bezeichnet) einer oder mehrerer der vorhandenen Reflektorstrukturen so auszubilden, daß diese Reflektorelemente in ihrer Längsrichtung mindestens einmal funktionell geteilt sind und die durch diese Teilung entstandenen Reflektorelement-Teilstücke in einer Haupt-Wellenausbreitungsrichtung gegeneinander um ein jeweils solches Maß versetzt sind, das der vorgegebenen Wichtung dieses betreffenden Reflektorelementes entspricht bzw. diese Wichtung erfüllt. Physikalisch gesehen ergibt sich für das Bauelement dieser älteren Europäischen Anmeldung, daß parallel zur betreffenden Haupt-Wellenausbereitungsrichtung wenigstens zwei streifenweise Bereiche vorliegen, in denen an Orten einer durchgeführten Wichtung die Reflektorelement-Teilstücke nicht nur gegenüber der ungewichteten Lage dieses Reflektorelementes (in Richtung der Haupt-Wellenausbreitungsrichtung) versetzt sind, sondern daß in dem einen von zwei Bereichen die Reflektorelement-Teilstücke im einen Sinne und im anderen Bereich im anderen Sinne gegenüber der ungewichteten Lage der Reflektorelemente versetzt sind.

Weitere Einzelheiten zu dieser älteren Europäischen Anmeldung gehen aus der nachfolgenden Beschreibung zu den Fig. 1 bis 4 hervor, wobei die Erfindung anhand des wichtigen Falles der Wichtung einer Reflektorstruktur beschrieben ist.

Fig. 1 zeigt eine prinzipielle Ausführungsform eines mit reflektierten akustischen Wellen arbeitenden Elektronik-Bauelementes mit Wellenreflexion in von 180° verschiedenem Winkel. Die dargestellten Strukturen bzw. die vorhandenen Reflektorelemerte sind vorzugsweise Metallisierungsstreifen, die sich auf der in der Fig. 1 oberen Oberfläche 3 des Substratkörpers 2 befinden. Mit 4 und 5 sind zwei an sich bekannte Interdigital-Wandlerstrukturen bezeichnet. Im Eingangswandler wird aus dem elektrischen Eingangssignal eine akustische Oberflächenwelle in dem zumindest dort piezoelektrischen Material der Oberfläche 3 des Substratkörpers 2 erzeugt. Mit dem anderen dieser Wandler kann aus der empfangenen akustischen Welle ein elektrisches Signal zurückgewonnen werden. Elektrisches Eingangssignal und Ausgangssignal unterscheiden sich entsprechend der für dieses Bauelement vorgegebenen Übertragungsfunktion.

Beim Beispiel der Fig. 1 ist der Wandler 4 als Eingang und der Wandler 5 als Ausgang angenommen, so daß sich Hauptwellenausbreitungsrichtungen ergeben, die durch die Pfeile 6, 7 und 8 angedeutet sind. Die somit in der Richtung des Pfeiles 6 laufende akustische Welle trifft auf eine erste Reflektorstruktur 11, die aus einer Vielzahl von in an sich bekannter Weise schräggestellten, streifenförmigen Reflektorelementen 12 besteht. Nach der an diesen Fingern 12 erfolgten Reflexion in Richtung des Pfeiles 8 trifft die akustische Welle auf die dargestellte zweite Reflektorstruktur, die aus einer Vielzahl wiederum schräggestellter Reflektorelemente 14 besteht. Nach an dieser Struktur 13 erfolgter Reflexion verläuft die Welle bzw. ist die Haupt-Wellenausbreitungsrichtung parallel der Richtung des Pfeiles 7.

Die jeweilige Länge einer Reflektorstruktur 11, 13 richtet sich in an sich bekannter Weise nach den vorgegebenen Anforderungen, die an das betreffende Elektronik-Bauelement gestellt werden.

In der Fig. 1 enthält die Reflektorstruktur 11 eine Reflektorelement-Wichtung, mit der die vorgegebene Übertragungsfunktion des Bauelementes im Hinblick auf die Amplitudenfunktion erfüllt wird. Etwaige notwendige Dispersionseigenschaft kann bei einem Bauelement nach Fig. 1 durch nichtäquidistante Abstände einzelner Reflektorelemente oder von Reflektorelement-Gruppen gegeneinander realisiert sein, wobei sich die diesbezüglich angesprochenen Abstände auf eine Lage der einzelnen Finger einer Digitalstruktur bezieht, die keine Dispersion (und auch keine Fingerwichtung) durch Reflektorelement-Verschiebung gemäß der noch älteren Anmeldungen hat. Bei dem Beispiel der Fig. 1 ist eine solche nicht dispersive, nicht gewichtete Reflektorstruktur mit der Struktur 13 wiedergegeben. Es sei aber darauf hingewiesen, daß bei diesem Beispiel der Fig. 1 auch der Struktur 13 dispersive und/oder gewichtete Eigenschaft durch Querverschiebung gegeneinander gegeben sein könnte.

In Fig. 1 sind diejenigen Reflektorelemente 12, die eine entsprechende Wichtung aufweisen, z. B. einmal in ihrer Länge unterteilt, so daß sich jeweils zwei Teilstücke 112, 212 des Reflektorelementes ergeben. Diese beiden Teilstücke sind gegeneinander um das sich aus der geforderten Wichtung ergebende Maß verschoben, und zwar in Fig. 1 parallel der Haupt-Wellenausbreitungsrichtung 6. Wie für Wichtung üblich, verteilt sich diese Wichtung nach Art einer Modulation auf die gesamte (mit Wichtung versehene) Reflektorstruktur 11. Für eine Verschiebung der Teilstücke 112 und 212 gegeneinander um das Maß/2 ergibt sich eine Wichtung einer Null-Stelle (die bei bekannter Überlappungswichtung einer Überlappung "Null" entsprechen würde). Ein Versatz der beiden Reflektorelement-Teilstücke 112, 212 in der Größe "Null", d. h. so wie sie bei den Fingern 12 in der Mitte der Struktur 11 vorliegt, entspricht einem Übertragungsmaximum (bzw. vollständigem Überlappen). Zwischenwerte des Versatzes der Teilstücke 112, 212 gegeneinander ergeben durch weniger starke Interferenz die entsprechenden Zwischenwerte einer Wichtung zwischen Übertragungsmaximum und -minimum. Es sei hier darauf hingewiesen, daß für den Versatz jeweils die Komponente parallel zur betreffenden Haupt-Wellenausbreitungsrichtung (hier Richtung des Pfeiles 6) maßgeblich ist. Beim Ausführungsbeispiel der Fig. 1 ist dies somit wegen der Schräglage der Finger 12 die Projektion auf die Richtung des Pfeiles 6.

Die Fig. 2, 3 und 4 zeigen nebeneinander für ein Reflektorelement (z. B. für einen Finger 12) eines Bauelementes mit schräggerichteter Reflektorstruktur drei Möglichkeiten des erfindungsgemäßen Wichtungsversatzes, nämlich Fig. 2 (wie schon in Fig. 1) den Versatz parallel zur Richtung des Pfeiles 6. Fig. 3 zeigt den Versatz (allein) in Richtung parallel zur Richtung des Pfeiles 8 und Fig. 4 zeigt einen Versatz teilweise parallel zur Richtung des Pfeiles 6 (oder 7) und teilweise parallel zur Richtung des Pfeiles 8. Insbesondere die der Fig. 2 entsprechende Maßnahme ist geeignet, denkbare Störungen zu minimieren, weil in Laufrichtung der Welle für diese kein Abstand zwischen den Teilstücken 112, 212 erscheint. Zu den Fig. 2 bis 4 sei darauf hingewiesen, daß sie wesentlich vergrößerte Ausschnitte vergleichsweise zur Größenordnung der Fig. 1 sind.

Wie schon oben angedeutet, kann auch die andere Reflektorstruktur 13 (anstelle der Reflektorstruktur 12) die voranstehend zur Struktur 11 beschriebene erfindungsgemäße Wichtung haben. Es kann die notwendige Wichtung auch auf beide Reflektorstrukturen 11, 13 verteilt sein. Damit kann z. B. erreicht werden, daß der notwendige Versatz entsprechend aufgeteilt kleiner ist.

Es sei darauf hingewiesen, daß ein einzelnes jeweiliges Reflektorelement in seiner Länge auch in mehr als nur zwei Teilstücken 112, 212 aufgeteilt sein kann. Eine mehrfache Unterteilung eines jeweiligen Reflektorelementes in Längsrichtung läßt eine Verfeinerung der betreffenden Struktur erreichen.

Es sei noch darauf hingewiesen, daß die zu einem Finger 12 gehörenden Teilstücke 112, 212 miteinander verbunden (312') sein können, wie dies in den Fig. 2 bis 4 gestrichelt angedeutet ist. Zusätzliche Effekte durch eine solche Verbindung 312' sind insbesondere bei Substratmaterial mit kleinem Kopplungsfaktor $k^2$ im allgemeinen vernachlässigbar. Die jeweiligen Abstände zwischen den benachbarten Enden der jeweiligen Teilstücke 112, 212 bzw. die Längen der einzelnen Verbindungen sind ohnehin um eine oder mehrere Größenordnungen kleiner als die Länge der Reflektorelemente 12 bzw. Teilstücke 112, 212. Bei Anordnungen mit Metallisierungsstreifen sind speziell bei hohem Kopplungsfaktor durch diese Verbindungen fließende Ströme zu berücksichtigen.

Aufgabe der vorliegenden Erfindung ist es, Maßnahmen für ein Elektronik-Bauelement mit gegeneinander versetzten Teilstücken von Reflektorelementen, insbesondere für ein Bauteil nach der EP-A-0 100 997, anzugeben, mit denen auf Justierungenauigkeiten beruhende Nachteile und/oder störende Temperatureinflüsse eliminiert werden können.

Diese Aufgabe wird für ein solches Bauelement mit den im Patentanspruch 1 angegebenen Maßnahmen behoben. Weitere Ausgestaltungen und Weiterbildungen der Erfindung gehen aus den Unteransprüchen hervor.

Die Fortpflanzungsrichtung (Fig. 1, Pfeile 6 bzw. 7 bzw. 8) einer in dem Bauelement angeregten akustischen Welle ist nicht nur von der Lage und Orientierung des die Welle erzeugenden (Eingangs-)Wandlers, sondern auch von anisotropen Eigenschaften des Substratkörpers und/oder Temperaturänderungen desselben abhängig. Z. B. für Lithiumniobat als Substratkörper 2 gibt es eine pure mode axis, auf die bezogen insbesondere die Wandler, d. h. die Haupt-Wellenfortpflanzungsrichtung, justiert werden. Ein in mehr oder weniger starkem Maße kaum zu vermeidender Justierfehler führt dazu, daß die tatsächliche Wellenfortpflanzungsrichtung 6' etwas schräg zur Orientierung 6 des als Eingang betriebenen Wandlers 4 verläuft. In der Annahme korrekter Justierung sind jedoch der Wandler 4 und die Reflektorstruktur 11 und dazu auch die übrigen Strukturen zueinander so angeordnet, als läge die gewünschte Fortpflanzungsrichtung 6 exakt vor.

Die Fortpflanzungsgeschwindigkeit der akustischen Welle in der mit 6 (bzw. mit 7) bezeichneten Fortpflanzungsrichtung $v_x$ ist wegen der Anisotropie des Substratkörpers 2 nicht gleich groß, wie die Schallgeschwindigkeit $v_y$ in der mit 8 bezeichneten Richtung ist. Der Reflexionswinkel der Reflexion an den Reflektorelementen 12 (bzw. 14) hängt aber vom Verhältnis $v_x/v_y$ ab. Hinzukommt, daß $v_x$ und $v_y$ unterschiedliches Temperaturverhalten haben, so daß der tatsächliche Reflexionswinkel eine Funktion der Temperatur ist. Das Ergebnis ist, daß - wenn nicht bereits die tatsächliche Richtung der Wellenfortpflanzung 6 von der vorgegebenen Richtung (insbesondere infolge einer Justierungenauigkeit) abweicht - bei Temperaturänderungen (außerdem auch) die vorgesehene Richtung der Wellenfortpflanzung 7 der in den Ausgangswandler 5 laufenden akustischen Welle nicht mehr exakt eingehalten ist.

Weitere Erläuterungen der Erfindung werden nachfolgend anhand der weiteren Figuren zu Ausführungsbeispielen der Erfindung gegeben.

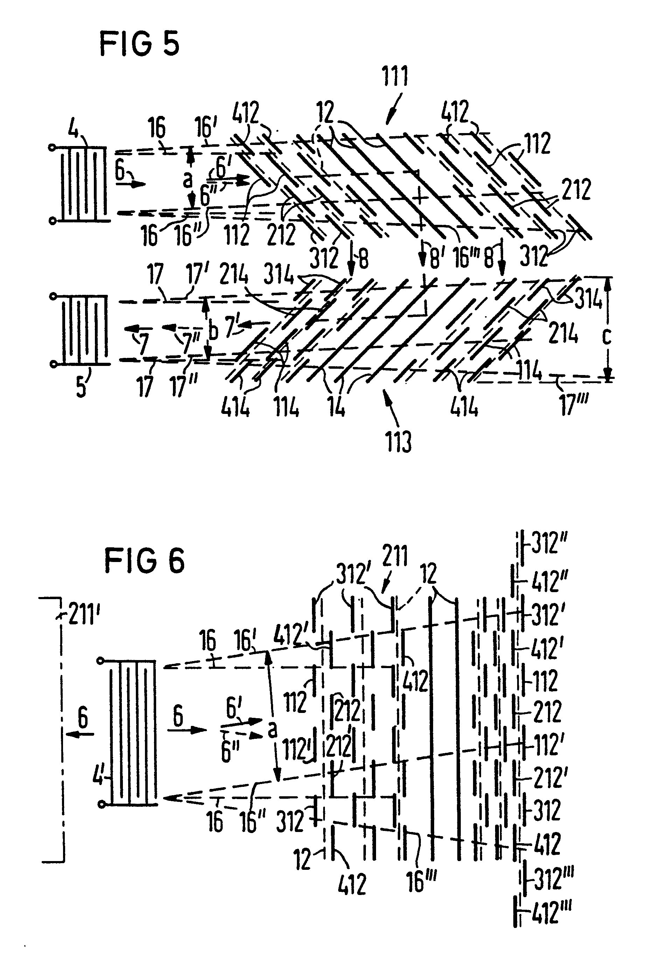

In Fig. 5 vorhandene, mit Fig. 1 übereinstimmende Elemente haben die bereits oben angegebenen Bezugzeichen.

Mit a ist auf diejenige Breitenabmessung der Reflektorstruktur hingewiesen, die gleich der aktiven Breite der angeregten akustischen Welle ist, wobei hier Beugungseffekte wegen der tatsächlichen auftretenden Abmessungen vernachlässigt werden. Die Abmessung a entspricht z. B. der ungewichteten Überlappungslänge der interdigitalen Finger des dargestellten Wandlers 4. Bei (Eingangs-)Wandlern anderer Art, wie z. B. am Substratkörper 2 angebrachten Scherschwingungs-Wandlern (für Volumen-Wellen u. dergl.), ist deren aktive Breite für die Breitenabmessung a maßgeblich. Bei exakter Wellenfortpflanzungsrichtung 6 würde es genügen (und das ist die bisherige Praxis), die Reflektorstruktur 111 wenigstens nicht nennenswert breiter als dieses Maß a zu machen.

Die erfindungsgemäße Ausführungsform der Fig. 5 ist so ausgebildet, daß mit ihr mehrere der oben erwähnten Mängel behoben bzw. kompensiert werden können.

Es sei hier angenommen, daß - beispielsweise infolge eines Justierfehlers (z. B. die Ausrichtung der Finger des Wandlers 4 ist fehlerhaft gegenüber der Kristallorientierung des Substrats 2) - die akustische Welle mit der Breite a vom Eingangswandler 4 ausgehend nicht in der Sollrichtung 6, sondern in der Richtung 6' verläuft, die gegenüber der Richtung 6 bzw. der Achse der Reflektorstruktur 111 einen Winkel von einigen Bogenminuten besitzt. Die in Richtung 6' verlaufende akustische Welle läuft also schräg (nach oben in der Darstellung der Fig. 5) zur Reflektorstruktur 111. Bei einer Anordnung nach Fig. 1 bedeutet dies, daß Anteile der akustischen Welle im Bereich des oberen Randes 16' der schräg laufenden Welle entweder überhaupt nicht auf Finger der Reflektorstruktur 11 (Fig. 1) treffen und/oder oder es würde sich ein Ungleichgewicht ergeben. Dieses Ungleichgewicht würde auch dann auftreten, wenn eine Struktur 11 nach Fig. 1 verwendet werden würde, für die man lediglich eine größere Breite a vorsieht. Bei der Erfindung ist aber, wie aus Fig. 5 ersichtlich, dafür Sorge getragen, daß auch kein derartiges Ungleichgewicht auftritt. Der benachbart dem oberen Rand 16' verlaufende Anteil der vom Wandler 4 ausgehenden akustischen Welle trifft dort auf die Finger-Teilstücke 412. Der energetische Anteil der akustischen Welle, der auf die zusätzlichen Teilstücke 412 trifft, ist aber ebenso groß wie derjenige energetische Anteil der akustischen Welle, um den vermindert Energie der (in Richtung 6' laufenden) akustischen Welle auf die Finger-Teilstücke 212 auftrifft. Die aus diesem Grunde in der Anordnung der Fig. 5 verminderte Wirksamkeit der Teilstücke 212 wird also durch die Wirkung der Teilstücke 412 kompensiert. Aus diesem Grunde ist auch die (gegenüber der bei fehlender Fingerwichtung geltenden Mittellage 12) vorzusehende Verschiebung der Teilstücke 412 nach Größe und Richtung genau die gleiche wie bei den Teilstücken 212. Die Teilstücke 412 stellen somit durch das jeweilige Teilstück 112 unterbrochene Fortsetzungen bzw. Verlängerunggen der Teilstücke 212 über den gegenüberliegenden oberen Rand 16 einer Reflektorstruktur 11 in Fig. 1 dar. Das entsprechende gilt für die Teilstücke 312, die Fortsetzungen bzw. Verlängerungen der Teilstücke 112 darstellen. Diese Teilstücke 312 werden aber bei der hier (gegenüber der Richtung 6) angenommenerweise nach oben abweichenden Richtung 6' nicht wirksam. Die Teilstücke 312 würden aber dann (in gleicher Weise wie zu den Teilstücken 412 beschrieben) wirksam werden, wenn die vom Wandler 4 ausgehende akustische Welle gegenüber der Sollrichtung 6 nach unten abweichend schräg laufen würde.

Diese Fortsetzungen 412, 312 sind wenigstens so lang bemessen, daß die auch am rechtsseitigen Ende der Reflektorstruktur 111 befindlichen Finger-Teilstücke 412 noch die gesamte mit der Breite a in der Reflektorstruktur 111 (jedoch fehlerhafterweise in Richtung 6') laufende akustische Welle erfassen. D. h., die Teilstücke 412 reichen auch am rechtsseitigen Ende der Reflektorstruktur 111 noch bis wenigstens an den Rand 16' der in fehlerhafter Richtung 6' verlaufenden akustischen Welle. Eine entsprechende Bemessung ist für die Teilstücke 312 vorgesehen. Wie dies nachfolgend noch eingehender zur Fig. 6 beschrieben ist, sollten die Teilstücke 412 bzw. 312 (jeweils) nicht länger gemacht werden als die Finger-Teilstücke 212 bzw. 112.

Selbst bei Reflexion mit dem vorgebbaren Winkel würde die akustische Welle aus der Richtung 6' abweichend von der angenommenen Sollrichtung 8 mit der Richtung 8' in die zweite Reflektorstruktur 113 hineinlaufen. Infolge der erfindungsgemäß zusätzlichen Teilstücke 314 und 414 am jeweiligen äußeren Rand der Reflektorstruktur 113 ist aber auch bei dieser Reflektorstruktur 113 dafür gesorgt, daß für die Fingerwichtung durch gegenseitige Verschiebung von Finger-Teilstücken 114, 214 das Gleichgewicht gewahrt bleibt, nämlich auch dann, wenn die von der Richtung 8 angenommenerweise abweichende Richtung 8' der akustischen Welle auftritt. Dies gilt im übrigen auch für den Fall, daß die Reflexion an der Struktur 111 tatsächlich mit einem von 90° verschiedenen Winkel an den Fingern 12 bzw. an den Finger-Teilstücken und an den erfindungsgemäß zusätzlich vorgesehenen Teilstücken 312 bzw. 412 erfolgt

Wie aus der Fig. 5 ersichtlich ist, gelangt die akustische Welle entsprechend der schrägen Richtung 7', abweichend von der Sollrichtung 7, (unter Außerachtlassung von Beugungseffekten) in den Ausgangswandler 5. Dieser hat die Empfangscharakteristik mit der Breite b, die im allgemeinen gleich der Breite a sein kann. Der Wandler 5 empfängt also die mit der Richtung 7' einfallende akustische Welle, weil erfindungsgemäß die Finger 14 (bzw. die einen jeweiligen gewichteten Finger bildenden, jeweils zusammengenommenen Teilstücke 114, 214, 314 und 414) der Reflektorstruktur 113 alle so lang sind bzw. die ganze Reflektorstruktur 113 so breit (c) bemessen ist, daß der in der Fig. 5 angedeutete Streifen mit den Rändern 17', 17" der Breite b auch bei einer Richtungsabweichung bis maximal in die Richtung 7' (gegenüber der Sollrichtung 7) stets noch innerhalb der Gesamtbreite c der Reflektorstruktur 113 verläuft. Die im Wandler 5 mit der Breite b empfangene Welle hat im Reflektor 111 aufgrund der dort vorgesehenen Fingerwichtung eine Beeinflussung erfahren, die wegen der erfindungsgemäßen Ausgestaltung dieser Reflektorstruktur 111 unabhängig ist von einer Richtungsabweichung aus der Richtung 6 bis maximal in eine Richtung 6' (wobei diese Richtung 6' als Maximum einer möglichen Abweichung angenommen ist). Außerdem hat diese im Wandler 5 empfangene Welle (im Falle einer Wichtung der Reflektorstruktur 113) zusätzlich noch diejenige Beeinflussung erfahren, die sich aus der Wichtung (d. h. der Anordnung der Teilstücke 114, 214, 314 und 414) dieser zweiten Reflektorstruktur 113 ergibt. Auch diese Beeinflussung durch die Wichtung der Reflektorstruktur 113 ist innerhalb einer Richtungsabweichung aus der Sollrichtung 7 bis maximal in die Richtung 7' (die als Maximum einer möglichen Richtungsabweichung angenommen ist) von einer Richtungsabweichung unabhängig, und zwar wiederum aufgrund der erfindungsgemäßen Ausgestaltung der Reflektorstruktur 113 (vergleichsweise zur Reflektorstruktur 13 der Fig. 1).

Eine Welle, die irgendwo zwischen den Richtungsverläufen 6, 8 und 7 einerseits und 6', 8' und 7' andererseits (oder 6, 8 und 7 einerseits und 6, 8' und 7' andererseits) gelaufen ist, hat aufgrund der Erfindung jeweils ein und dieselbe Wichtungsbeeinflussung in den Reflektorstrukturen 111 und/oder 113 erfahren.

Die Teilstücke 414 sind Fortsetzungen bzw. Verlängerungen der Finger-Teilstücke 214 und die Finger-Teilstücke 314 sind Fortsetzungen bzw. Verlängerungen der Finger-Teilstücke 114, nämlich hinsichtlich ihrer Funktion als durch Verschiebung gewichtete Finger.

Bei der Ausführungsform nach Fig. 5 hat die Reflektorstruktur 111 Reflektorfinger 12 (die im Falle einer Wichtung des Fingers aus den jeweiligen Teilstücken 112, 212, 312 und 412 bestehen), die in schräger Richtung bezogen zur Ausrichtung der Finger des (Eingangs-)Wandlers 4 ausgerichtet sind. Der Winkel dieser Schrägstellung der Reflektorfinger 12 ergibt sich aus dem gewünschten Weg der Richtungen 6 und 8 bzw. aus dem Winkel zwischen diesen Richtungen 6 und 8. Lediglich der Vollständigkeit halber sei nochmals darauf hingewiesen, daß für die Wahl dieses Winkels der Schrägstellung der Reflektorfinger ein anisotropes Verhalten des Materials des Substrats mit zu berücksichtigen ist.

Gibt man den Reflektorfingern 12, abweichend von der Darstellung der Fig. 5, eine Ausrichtung, die parallel zur Ausrichtung der Finger des Wandlers 4 ist (siehe Fig. 6), so erhält man eine Ausführungsform mit in sich reflektierter Welle. Eine solche Ausführungsform wird als in-line-RAC bezeichnet. Der in Fig. 5 mit 4 bezeichnete Eingangswandler kann bei einem solchen in-line-RAC auch als Ausgangswandler verwendet werden. Im allgemeinen werden solche in-line-RAC-Anordnungen so ausgeführt, daß auf beiden Seiten eines solchen Eingangs- und Ausgangswandlers 4', nämlich in beiden Richtungen der Wellenabstrahlung eines solchen Wandlers, solche wie voranstehend beschriebenen Reflektorstrukturen mit 180°-Reflexion (d. h. mit parallel zu den Wandlerfingern ausgerichteten Reflektorfingern) vorgesehen sind. Bei einer solchen in-line-RAC-Anordnung kann die Reflektorstruktur - abgesehen von dieser Parallelausrichtung der Reflektorfinger zu denen des Wandlers - hinsichtlich der Aufteilung der einzelnen Reflektorfinger in Teilstücke 112, 212 und ihre Fortsetzungen 312 und 412 genauso wie eine Struktur 111 (bzw. 113) nach Fig. 5 ausgebildet sein. Eine solche Reflektorstruktur hat dann die gleiche Fingerwichtung wie die Reflektorstruktur 111 und diesbezüglich das gleiche Übertragungsverhalten für die Welle.

Fig. 6 betrifft ein in-line-RAC, von dem der Eingangs- und Ausgangswandler 4' und ein Abschnitt einer auf der rechten Seite des Wandlers 4' angeordneten Reflektorstruktur 211 dargestellt ist. Lediglich schematisch angedeutet ist, daß auch auf der linken Seite des Wandlers 4; eine entsprechende Reflektorstruktur angeordnet sein kann, die insbesondere identisch der Reflektorstruktur 211 sein kann. Die voranstehend zu einem in-line-RAC beschriebenen Einzelheiten gelten auch für die Ausführungsform nach Fig. 6, die eine weitere Ausgestaltung zeigt bzw. die Erfindung noch weiter ins einzelne gehend erläutert.

Wie in Fig. 6 dargestellt, hat ein in Teilstücke 112, 212 sowie 112', 212' aufgeteilter und durch jeweilige Verschiebung dieser Teilstücke gegeneinander bzw. gegenüber der Lage des betreffenden ungewichteten Reflektorfingers gebildeter gewichteter Reflektorfinger innerhalb des durch Grenzungen 16 definierten Streifens eine solche Aufteilung, daß zwei Teilstücke 112, 112' und zwei Teilstücke 212, 212' vorliegen. Die Verschiebung dieser je zwei Teilstücke entspricht genau derselben Wichtung, wie sie bei der Ausführungsform nach Fig. 5 mit (innerhalb des durch die Grenzen 16 bestimmten Streifens) nur jeweils einmal geteiltem Reflektorfinger der Fall ist. Diese bei der Fig. 6 dreimalige Unterteilung (innerhalb des Streifens 16) führt dazu, daß im Falle ungleichmäßiger Intensitätsverteilung innerhalb der Breite der vom Wandler 4' ausgesandten Welle diese Welle innerhalb der Reflektorstruktur ein geringeres Ungleichgewicht der Wichtung erfährt. Diese Betrachtung gilt bereits dann, wenn die vomWandler 4' ausgesandte Welle exakt in der Richtung 6 ausgesandt wird, d. h. innerhalb des durch die Grenzen 16 gebildeten Streifens wunschgemäß verläuft.

Die in Fig. 6 dargestellte Aufteilung in je zwei Teilstücke 112, 112' und 212, 212' innerhalb des durch die Grenzen 16 gebildeten Streifens kann mit entsprechendem technologischen Aufwand noch feiner in z. B. sechs, acht, zehn Teilstücke 112 und 212 erfolgen. In jedem Fall weist diese Aufteilung in Querrichtung (quer zur Richtung 6) eine jeweilige Folge von Teilstücken auf. Diese Folge kann innerhalb der Grenzen 16 in sich eine Periodizität haben.

Für die erfindungsgemäße Fortsetzung eines jeweiligen Reflektorfingers über die Grenzen 16 hinaus ist jeweils eine wenigstens teilweise Wiederholung derjenigen Folge vorzusehen, die innerhalb der Grenzen 16 für diesen betreffenden Reflektorfinger vorliegt. Diese Wiederholungen sind bis wenigstens an die Ränder 16', 16''' fortzusetzen, wie dies der Figur zu entnehmen ist. Das Teilstück 412', mit dem ein Reflektorfinger über den oberen Rand 16 hinaus fortgesetzt wird, ist so lang zu bemessen und ebenso weit versetzt angeordnet, wie das an den unteren Rand 16 anstoßende Teilstück 212'. Entsprechend folgt das oben weiter fortsetzende Teilstück 312' mit einer Länge und einem Versatz, wie sie beim Teilstück 112' vorliegen. Eine analoge Fortsetzung der innerhalb der Ränder 16 vorliegenden Folge der Teilstücke 212', 112', 212, 112, die für oberhalb des Randes 16 beschrieben ist, ist auch für die Fortsetzung des betreffenden Reflektorfingers unterhalb des Randes 16 vorzusehen. Dort wird die entsprechende Folge der Teilstücke 112, 212, 112', 212' durch eine Folge von Teilstücken 312, 412 und gegebenenfalls 312'', 412'') fortzusetzen.

In Fig. 6 ist der Fall eingetragen, daß die vom Wandler 4' mit der Breite a ausgesandte Welle (an sich unerwünschterweise) in einer abweichenden Richtung 6' in der Reflektorstruktur 211 verläuft. Wie aus der Fig. 6 ersichtlich, werden ausgehend vom Wandler 4' von der in Richtung 6' laufenden Welle zunächst die Teilstücke 412' oberhalb des oberen Randes 16 in zunehmendem Maße erfaßt, und zwar erfindungsgemäß in genau dem gleichen Maße, wie die Teilstücke 212' am unteren Rand 16 von der Welle (siehe die Begrenzung 16'') zunehmend nicht mehr erfaßt werden. Bei entsprechend starker Abweichung, insbesondere im Bereich des äußeren Endes der Reflektorstruktur 211, trifft diese in Richtung 6' laufende Welle sogar auf Teilstücke 312', die oberhalb des oberen Randes 16 gemäß der Lehre der Erfindung vorgesehen sind. Die oberhalb des Randes 16 befindlichen Teilstücke 412' sind dann bereits voll erfaßt und dafür werden dort am Ende die an den unteren Rand 16 angrenzenden Teilstücke 212' überhaupt nicht mehr erfaßt. Im weiteren Verlauf werden dort am Ende sogar zunehmend die Teilstücke 112' der unteren Hälfte des durch die Grenzen 16 gegebenen Streifens nicht mehr erfaßt, nämlich im gleichen Maße wie die Teilstücke 312' oberhalb des Randes 16 zunehmend von der Welle erfaßt werden.

Sollten die (z. B. außerhalb des oberen Randes 16 vorgesehenen) jeweils zwei Finger-Teilstücke 412' und 312' noch nicht ausreichen, um den Streifen mit den Rändern 16', 16'' zu erfassen, werden (siehe die beiden letzten Reflektorfinger am rechtsseitigen Ende der Fig. 6) jeweils weitere Teilstücke 412'' und dann 312'' angeordnet, die die Wiederholung der Teilstücke 212, 112 sind. D.h., daß dort dann die ganze Folge 212', 112', 212, 112 als Periode wiederholt ist. Entsprechend ist also dann, wenn nur die Teilstücke 412' und 312 oder nur die Teilstücke 412', 312' bzw. 312 und 412 hinzugefügt sind, die Periode der Folge der Teilstücke 312, 412, 312', 412' der Hauptspur (16) nur im Ansatz fortgesetzt.

Aus der voranstehenden Erläuterung ist ersichtlich, wie mit der Erfindung das Gleichgewicht der Wichtung auch für eine unerwünschterweise in der Richtung 6' laufende Welle beibehalten bleibt.

Wie bereits erwähnt, läuft die in die Reflektorstruktur 211 hineingelaufene, vom Wandler 4' ausgegangene Welle nach erfolgter Reflexion an den ungewichteten Reflektorfingern 12 und den gewichteten Reflektorfingern, die aus den Teilstücken bestehen, in sich wieder zurück in den Wandler 4'. Auch die Wellenfront der Welle bleibt trotz schräger Richtung 6' - von sonstigen Störungen höherer Ordnung abgesehen - parallel der Ausrichtung der Finger des Wandlers 4' und beim in-line-RAC auch parallel zur Ausrichtung der Reflektorfinger der Reflektorstruktur 211.

In der vorangehenden Beschreibung sind Abweichungen nach nach oben (6 6', 7 7' bzw. 16 16' und 16'') ins einzelne gehend erörtert. Mit 16''' ist ein entsprechender Rand für maximal mögliche Richtungsabweichung 6'', 7'' nach unten eingetragen. Für die Erfindung sind entsprechend (wie in den Figuren berücksichtigt) beide äußerste Ränder 16' und 16''' zu berücksichtigen. Der Rand 17''' weist auf das Entsprechende zur Struktur 113 hin.

Die zu den Teilstücken 312'' und 412'' entsprechende Fortsetzung des Teilstückes 112' und dann des Teilstückes 212' (d. h. die Verlängerung des betreffenden Reflektorfingers über das Teilstück 412 hinaus) besteht zunächst in dem Teilstück 312''' und dann im Teilstück 412'''.

Die Ausführungsbeispiele zeigen fingerförmige Reflektorelemente 12, 13, 112, 212 bzw. ihre Teilstücke 112, 212, 312 ..., die vorzugsweise auf der Substratoberfläche angebrachte Metallisierungsstreifen sind. Bei Verwendung von Metallisierungsstreifen ist im Regelfall ein piezoelektrisches Substrat vorgesehen. Für Reflektorelemente können auch als Gruben bzw. Gräben ausgeführte Elemente (grooves) verwendet werden. Als Reflektorelemente werden auch 'dots' angewendet.

## Patentansprüche

Mit reflektierten akustischen Wellen arbeitendes Elektronik-Bauelement mit Finger-Wichtung, wobei zu wichtende Finger der gewichteten Struktur vergleichsweise zu ungewichteten Fingern in ihrer Längsrichtung mindestens einmal funktionell geteilt sind, wobei auf einzelne Finger angewendete Finger-Verschiebungswichtung bezogen auf eine der vorgegebenen Haupt-Wellenausbreitungsrichtungen vorgesehen ist und die lediglich durch Teilung eines entsprechenden nichtgewichteten Fingers entstandenen Finger-Teilstücke entsprechend der Wichtungsverschiebung gegenüber der ungewichteten Fingerposition jeweils entgegengesetzt zueinander, parallel zur vorgegebenen Haupt-Wellenausbreitungsrichtung um das der vorgegebenen Wichtung dieses jeweiligen Fingers entsprechende Maß versetzt angeordnet sind,
gekennzeichnet dadurch,
- daß zusätzliche Finger-Teilstücke (312, 412 bis 312''', 412''', 314', 414) vorgesehen sind, die zu den jeweiligen Finger-Teilstücken (112, 212, 112', 212'; 114, 214) eines jeweiligen gewichteten Fingers zugeordnete, diesen Finger verlängernde Fortsetzungen sind,
- wobei diese zusätzlichen Finger-Teilstücke (312, 412 bis 312''', 412'''; 314, 414) außerhalb des jeweiligen Streifens (16 - 16; 17 - 17) angeordnet sind, der durch die Apertur (a; b) des Eingangs-bzw. Ausgangswandlers (4, 5; 4') im Idealfall als Hauptspur 6; 7) bestimmt ist,
- wobei sich vom jeweiligen Rand (16; 17) ausgehend nach beiden Seiten diejenige Wichtungsaufteilung (112 - 212'; 114 - 214) des betreffenden gewichteten Fingers, die als eine Folge der Finger-Teilstücke (112, 212, 112', 212'; 314, 414) innerhalb des durch die Ränder 16 - 16; 17 - 17) gebildeten Streifens der Hauptspur (6; 7) vorliegt, als wenigstens im Ansatz periodisch wiederholte Folge fortsetzt,
- wobei diese Fortsetzung wenigstens bis zu den Rändern (16', 16'''; 17', 17'''') realisiert ist, die sich aus derjenigen Apertur (a; b) und den als maximal zu erwartenden Richtungsabweichungen (6', 6''; 7', 7'') einer tatsächlich auftretenden Haupt-Wellenausbreitungsrichtung ergibt,
- daß vorhandene ungewichtete Finger (12; 14) bis wenigstens an diese sich aus der Richtungsabweichung (6'; 7') ergebende Ränder (16', 16'''; 17', 17'''') verlängert sind.

2. Elektronik-Bauelement nach Anspruch 1, gekennzeichnet dadurch,
daß jeweils nur ein zusätzliches Finger-Teilstück (312, 412; 312', 412'; 314, 414) außerhalb des jeweiligen unteren und/oder oberen Randes (16, 17) vorgesehen ist, wobei die Wichtungsverschiebung des einen betreffenden zusätzlichen Finger-Teilstückes gleich derjenigen Wichtungsverschiebung ist, die dasjenige innerhalb der Hauptspur (16 - 16; 17 - 17) vorhandene Finger-Teilstück (112, 212; 114, 214) hat, das an den jeweils gegenüberliegenden Rand (16; 17) der Hauptspur angrenzt (Fig. 1).

3. Elektronik-Bauelement nach Anspruch 1 oder 2,

gekennzeichnet dadurch,

daß die Finger-Teilstücke Teilstücke von Reflektorelementen einer Reflektorstruktur sind.

## Claims

1. Finger-weighted electronic device operating with reflected acoustic waves, fingers to be weighted in the weighted structure being divided, by comparison with unweighted fingers, at least once in a functional fashion in their longitudinal direction,

there being provided finger displacement weighting applied to individual fingers relative to one of the predetermined principal directions of wave propagation, and the finger segments produced purely by division of an appropriate non-weighted finger being, in accordance with the weighting displacement as compared with the unweighted finger position, arranged in each case opposite one another, offset parallel to the predetermined principal direction of wave propagation by the measure corresponding to the predetermined weighting of this particular finger, characterized in that

- additional finger segments (312, 412 to 312''', 412''', 314', 414) are provided, which are continuations associated with the particular finger segments (112, 212, 112', 212'; 114, 214) of a particular weighted finger and extending that finger,

- these additional finger segments (312, 412 to 312''', 412'''; 314, 414) being arranged outside the particular strip (16 - 16; 17 - 17), which is defined as principal track (6; 7) in the ideal case by the aperture (a; b) of the input or output transducer (4, 5; 4'),

- the weighting distribution (112 - 212'; 114 - 214) of the weighted finger concerned which occurs as a sequence of the finger segments (112, 212, 112', 212'; 314, 414) inside the strip of the principal track (6; 7) formed by the edges (16 - 16; 17 - 17) being continued to both sides, starting from the particular edge (16; 17), as an at least incipiently perodically repeated sequence,

- this continuation being realized at least as far as the edges (16', 16'''; 17', 17''') which arises (sic) from that aperture (a; b) and from the deviations in direction (6', 6''; 7', 7'') of an actually occurring principal direction of wave propagation that are to be expected as maximal,

- and in that existing unweighted fingers (12; 14) are extended at least as far as these edges (16', 16'''; 17', 17'''') arising from the deviation in direction (6'; 7').

2. Electronic device according to Claim 1, characterized in that

in each case only one additional finger segment (312, 412; 312', 412'; 314, 414) is provided outside the particular lower and/or upper edge (16, 17), the weighting displacement of the additional finger segment concerned being equal to that weighting displacement which has that finger segment (112, 212; 114, 214) present inside the principal track (16 - 16; 17 - 17) which adjoins the particular opposite edge (16; 17) of the principal track (Figure 1).

3. Electronic device according to Claim 1 or 2, characterized in that

the finger segments are segments of reflector elements of a reflector structure.

## Revendications

1. Composant électronique à pondération des doigts, opérant avec des ondes acoustiques réfléchies, du type dans lequel des doigts à pondérer de la structure pondérée sont, comparativement à des doigts non pondérés, fonctionnellement subdivisés une fois dans le sens de leur longueur et du type dans lequel il est prévu d'appliquer à des doigts individuels une pondération par déplacement de doigts par rapport à l'une des directions principales de propagation des ondes, alors que les pièces des doigts partielles qui ont été formées par simple subdivsion d'un doigt correspondant non pondéré sont, en fonction du déplacement de la pondération par rapport à la position du doigt non pondérée, disposées avec décalage opposé entre elles et parallèlement à la direction principale et prédéterminée de la propagation des ondes, d'une valeur qui correspond à la pondération prédéterminée du doigt considéré, caractérisé par le fait

- que des pièces de doigts partielles (312, 412 à 312''', 412''', 314', 414) sont prévues, qui sont associées aux pièces de doigts partielles (112, 212, 112', 212'; 114, 214) d'un doigt pondéré et sont des prolongements qui rallongent ces doigts,

- ces pièces de doigts partielles supplémentaires (312, 412, 312''', 412'''; 314, 414) étant disposées en dehors de la bande (16 - 16 ; 17 - 17) qui est déterminée par l'ouverture (a; b) du transducteur d'entrée et de sortie (4, 5; 4'), dans le cas idéal comme piste principale (6; 7),

- alors qu'en partant de chaque bord et sur les deux côtés la répartition de la pondération (112 - 212; 114 - 214) du doigt pondéré concerné qui se présente sous la forme d'une série de pièces de doigts partielles (112, 212, 112', 212'; 314, 414) à l'intérieur de la bande de la piste principale (6; 7), formée par les bords (16 - 16); 17 - 17), se poursuit sous la forme d'une série périodiquement répétitive, au moins à l'appendice,

- et que ce prolongement est réalisé au moins jusqu'aux bords (16', 16'''; 17', 17'''), qui résulte de l'ouverture (a; b) et des écarts maximum de directions (6', 6''; 7', 7'') auxquels il faut s'attendre, d'une direction principale de propagation des ondes se présentant effectivement, et par le fait

- que des doigts pondérés (12; 14) qui sont présents, sont prolongés jusqu'à ces bords (16, 16'''; 17', 17''') qui résultent de cet écart de direction (6'; 7').

2. Composant électronique selon la revendication 1, caractérisé par le fait qu'il est prévu en dehors du bord inférieur et/ou supérieur concerné (16, 17) une seule pièce de doigt partielle supplémentaire (312, 412; 312', 412'; 314, 414), étant noté que le décalage de la pondération de ladite pièce de doigt supplémentaire est égal au décalage de la pondération affectée à la pièce de doigt partielle (112, 212; 114, 214) qui est présente à l'intérieur de la piste principale (16 - 16; 17 - 17) et qui jouxte le bord opposé de la piste principale (16; 17) (figure 1).

3. Composant électronique selon la revendication 1 ou 2, caractérisé par le fait que les pièces de doigts partielles sont des pièces partielles d'éléments-réflecteurs d'une structure à réflecteurs.

FIG 1

FIG 2   FIG 3   FIG 4

FIG 5

FIG 6